# EUROPEAN PATENT APPLICATION

(11) **EP 3 018 716 A1**
(43) Date of publication of application: **11.05.2016**
(21) Application number: 15003142.5
(22) Date of filing: 03.11.2015
(51) Int. Cl.: H01L 31/0224, H01L 31/0328, H01L 31/0352, H01L 31/074, H01L 31/18

(54) **SOLAR CELL**

(30) Priority: 04.11.2014 KR 20140152377
(71) Applicant: LG Electronics Inc., Seoul 07336 (KR)
(72) Inventor: LEE, Yujin, 08592 Seoul (KR); CHUNG, Jinwon, 08592 Seoul (KR)
(74) Representative: Katérle, Axel

(57) **Abstract**

A solar cell is discussed. The solar cell according to an embodiment includes a semiconductor substrate containing impurities of a first conductive type, a metal oxide layer positioned on the semiconductor substrate, an emitter region positioned on the metal oxide layer and having a second conductive type opposite the first conductive type, a first electrode connected to the emitter region, and a second electrode connected to the semiconductor substrate.

## Description

### CROSS-REFERENCE TO RELATED APPLICATION

This application claims priority to and the benefit of Korean Patent Application No. 10-2014-0152377 filed in the Korean Intellectual Property Office on November 4, 2014, the entire content of which is incorporated herein by reference.

### BACKGROUND OF THE INVENTION

### Field of the Invention

The present disclosure relates to a solar cell.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

The solar cells each having the above-described configuration may be connected to one another through interconnectors.

### SUMMARY OF THE INVENTION

In one aspect, there is a solar cell including a semiconductor substrate containing impurities of a first conductive type, a metal oxide layer positioned on the semiconductor substrate, an emitter region positioned on the metal oxide layer and having a second conductive type opposite the first conductive type, a first electrode connected to the emitter region, and a second electrode connected to the semiconductor substrate.

A metal included in the metal oxide layer may include at least one of a transition metal or a post-transition metal.

For example, the metal oxide layer may be formed of one of NiO, TiO₂, HfO₂, ZrO, WO, CuO, Ta₂O₅, and Al₂O₃.

The metal oxide layer and the emitter region may be positioned on a back surface of the semiconductor substrate.

The solar cell may further include a back surface field region positioned on the metal oxide layer and containing impurities of the first conductive type at a higher concentration than the impurities of the semiconductor substrate. The emitter region and the back surface field region may be formed of a polycrystalline silicon material.

The solar cell may further include an intrinsic semiconductor layer positioned on a back surface of the metal oxide layer. The emitter region and the back surface field region may be positioned to be separated from each other with the intrinsic semiconductor layer interposed therebetween.

The solar cell may further include a tunnel layer positioned between the semiconductor substrate and the metal oxide layer and configured to pass through carriers produced in the semiconductor substrate, the tunnel layer being formed of a dielectric material.

A thickness of the metal oxide layer may be greater than a thickness of the tunnel layer and may be less than a thickness of the emitter region or a thickness of the back surface field region. More specifically, the thickness of the metal oxide layer is 5 nm to 50 nm.

When a voltage equal to or greater than a critical voltage is applied to front and back surfaces of the metal oxide layer, the metal oxide layer may have a resistance equal to or less than 10 Ω and greater than 0 Ω. Further, when a voltage less than the critical voltage is applied to the front and back surfaces of the metal oxide layer or a voltage is not applied to the front and back surfaces of the metal oxide layer, the metal oxide layer may have a resistance of 10 MΩ to 100 MΩ. The critical voltage may be 0.7V to 1V.

When the solar cell operates, carriers produced in the semiconductor substrate may move through a first portion in the metal oxide layer between the semiconductor substrate and the emitter region and a second portion in the metal oxide layer between the semiconductor substrate and the back surface field region and may not move through a third portion in the metal oxide layer between the semiconductor substrate and the intrinsic semiconductor layer.

The dielectric material of the tunnel layer may include silicon carbide (SiCx) or silicon oxide (SiOx). The tunnel layer may have a thickness of 0.5 nm to 2.5 nm.

The solar cell may further include a passivation layer positioned on back surfaces of the emitter region, the back surface field region, and the intrinsic semiconductor layer. The passivation layer may include at least one of hydrogenated silicon nitride (SiNx:H), hydrogenated silicon oxide (SiOx:H), hydrogenated silicon nitride oxide (SiNxOy:H), hydrogenated silicon oxynitride (SiOxNy:H), or hydrogenated amorphous silicon (a-Si:H).

In another aspect, there is a solar cell including a semiconductor substrate; an emitter region, a back surface field region, and an intrinsic region positioned on the semiconductor substrate; and a metal oxide layer positioned between the semiconductor substrate and the emitter region, the back surface field region, and the intrinsic region, wherein the metal oxide layer blocks a leakage current of the semiconductor substrate.

The metal oxide layer may have a thickness of 5nm to 50 nm.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 and 2 illustrate a solar cell according to an example embodiment of the invention; and
FIGS. 3 to 5 illustrate a method for driving a solar cell including a metal oxide layer according to an example embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" may be one surface of a semiconductor substrate, on which light is directly incident, and "back surface" may be a surface opposite the one surface of the semiconductor substrate, on which light is not directly incident or reflective light may be incident.

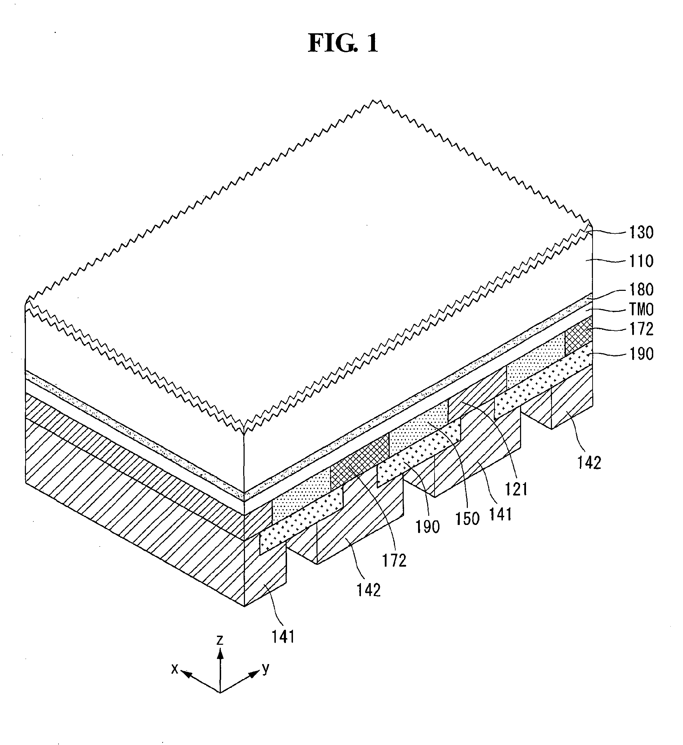

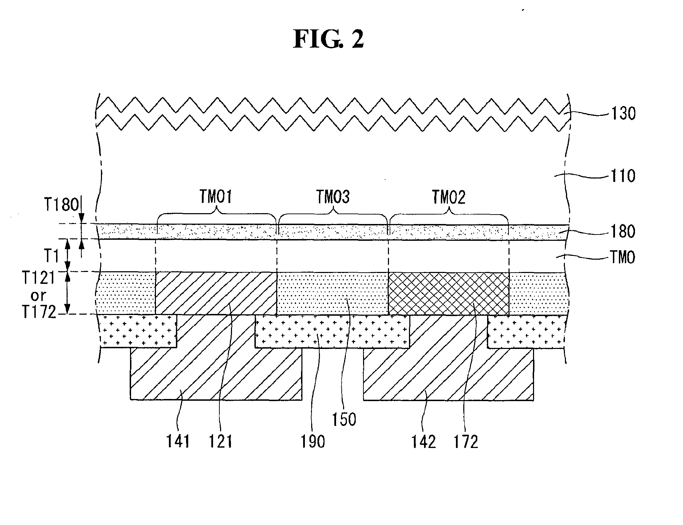

FIGS. 1 and 2 illustrate a solar cell according to an example embodiment of the invention. More specifically, FIG. 1 is a partial perspective view of the solar cell according to the embodiment of the invention, and FIG. 2 is a partial cross-sectional view taken along a second direction of the solar cell of FIG. 1.

As shown in FIGS. 1 and 2, a solar cell according to the embodiment of the invention may include an anti-reflection layer 130, a semiconductor substrate 110, a tunnel layer 180, a metal oxide layer TMO, a plurality of emitter regions 121, a plurality of back surface field regions 172, an intrinsic semiconductor layer 150, a passivation layer 190, a first electrode 141, and a second electrode 142.

In the embodiment disclosed herein, the anti-reflection layer 130, the tunnel layer 180, and the passivation layer 190 may be omitted, if desired or necessary. However, when the solar cell includes the anti-reflection layer 130, the tunnel layer 180, and the passivation layer 190, efficiency of the solar cell may be further improved. Thus, the embodiment of the invention is described using the solar cell including the anti-reflection layer 130, the tunnel layer 180, and the passivation layer 190 as an example.

The semiconductor substrate 110 may be formed of at least one of single crystal silicon, polycrystalline silicon, or amorphous silicon containing impurities of a first conductive type. For example, the semiconductor substrate 110 may be formed of a crystalline silicon wafer.

In the embodiment disclosed herein, the first conductive type may be one of an n-type and a p-type.

When the semiconductor substrate 110 is of the p-type, the semiconductor substrate 110 may be doped with impurities of a group III element such as boron (B), gallium (Ga), and indium (In). Alternatively, when the semiconductor substrate 110 is of the n-type, the semiconductor substrate 110 may be doped with impurities of a group V element, such as phosphorus (P), arsenic (As), and antimony (Sb).

In the following description, the embodiment of the invention is described using an example where the first conductive type is the n-type.

A front surface of the semiconductor substrate 110 may be textured to form a textured surface corresponding to an uneven surface having a plurality of uneven portions or having uneven characteristics. Thus, the anti-reflection layer 130 positioned on the front surface of the semiconductor substrate 110 may have a textured surface.

Hence, the anti-reflection layer 130 may reduce an amount of light reflected from the front surface of the semiconductor substrate 110 and may increase an amount of light incident on the inside of the semiconductor substrate 110.

The anti-reflection layer 130 is positioned on the front surface of the semiconductor substrate 110, so as to minimize the reflection of light incident on the front surface of the semiconductor substrate 110 from the outside. The anti-reflection layer 130 may be formed of at least one of aluminum oxide (AlOx), silicon nitride (SiNx), silicon oxide (SiOx), and silicon oxynitride (SiOxNy). As shown in FIGS. 1 and 2, the anti-reflection layer 130 may have a single layer. Alternatively, the anti-reflection layer 130 may have a plurality of layers.

The tunnel layer 180 directly contacts an entire back surface of the semiconductor substrate 110 and is positioned on the entire back surface of the semiconductor substrate 110. The tunnel layer 180 may include a dielectric material. Thus, as shown in FIGS. 1 and 2, the tunnel layer 180 may be formed between the back surface of the semiconductor substrate 110 formed of single crystal silicon and a front surface of the metal oxide layer TMO while directly contacting the semiconductor substrate 110 and the metal oxide layer TMO.

The tunnel layer 180 may pass through carriers produced in the semiconductor substrate 110 and may perform a passivation function with respect to the back surface of the semiconductor substrate 110.

The tunnel layer 180 may be formed of a dielectric material including silicon carbide (SiCx) or silicon oxide (SiOx) having strong durability at a high temperature equal to or higher than 600 °C. In addition, the tunnel layer 180 may be formed of silicon nitride (SiNx), hydrogenated SiNx, aluminum oxide (AlOx), silicon oxynitride (SiON), or hydrogenated SiON. A thickness T180 of the tunnel layer 180 may be 0.5 nm to 2.5 nm.

As shown in FIGS. 1 and 2, the metal oxide layer TMO is positioned on the back surface of the semiconductor substrate 110. More specifically, the metal oxide layer TMO may be positioned on a back surface of the tunnel layer 180 positioned on the back surface of the semiconductor substrate 110 while directly contacting the back surface of the tunnel layer 180. The metal oxide layer TMO may block a leakage current, which causes a portion of carriers produced in the semiconductor substrate 110 to be recombined and disappeared or annihilated in the intrinsic semiconductor layer 150.

The emitter region 121 directly contacts a portion of a back surface of the metal oxide layer TMO. The plurality of emitter regions 121 extend in a first direction x. The emitter region 120 may be formed of polycrystalline silicon material of a second conductive type opposite the first conductive type. The emitter region 120 may form a p-n junction along with the semiconductor substrate 110 with the tunnel layer 180 interposed therebetween.

Because each emitter region 121 forms the p-n junction along with the semiconductor substrate 110, the emitter region 121 may be of the p-type. However, if the semiconductor substrate 110 is of the p-type unlike the embodiment described above, the emitter region 121 may be of the n-type. In this instance, separated electrons may move to the plurality of emitter regions 121, and separated holes may move to the plurality of back surface field regions 172.

Returning to the embodiment of the invention, when the emitter region 121 is of the p-type, the emitter region 121 may be doped with impurities of a group III element such as B, Ga, and In. On the contrary, if the emitter region 121 is of the n-type, the emitter region 121 may be doped with impurities of a group V element such as P, As, and Sb.

The emitter regions 121 may be formed by depositing an intrinsic polycrystalline silicon layer on the back surface of the metal oxide layer TMO and then injecting impurities of the second conductive type into the intrinsic polycrystalline silicon layer. Alternatively, the emitter regions 121 may be formed by depositing an intrinsic amorphous silicon layer on the back surface of the metal oxide layer TMO, recrystallizing the intrinsic amorphous silicon layer into an intrinsic polycrystalline silicon layer through a thermal processing operation, and injecting impurities of the second conductive type into the recrystallized intrinsic polycrystalline silicon layer.

The back surface field region 172 directly contacts a partial area that is separated from the emitter region 121 in the back surface of the metal oxide layer TMO. The plurality of back surface field regions 172 may extend in the same first direction x as the plurality of emitter regions 121.

The back surface field regions 172 may be formed of polycrystalline silicon material doped with impurities of the first conductive type at a higher concentration than the semiconductor substrate 110. Thus, when the semiconductor substrate 110 is doped with, for example, n-type impurities, the plurality of back surface field regions 172 may be an n⁺-type region.

A potential barrier is formed by a difference between impurity concentrations of the semiconductor substrate 110 and the back surface field regions 172. Hence, the back surface field regions 172 can prevent or reduce holes from moving to the back surface field regions 172 used as a moving path of electrons through the potential barrier and can make it easier for carriers (for example, electrons) to move to the back surface field regions 172.

Thus, the back surface field regions 172 can reduce an amount of carriers lost by a recombination and/or a disappearance of electrons and holes at and around the back surface field regions 172 or the first and second electrodes 141 and 142 and can accelerate a movement of electrons, thereby increasing an amount of electrons moving to the back surface field regions 172.

The back surface field regions 172 may be formed using the same method as the emitter regions 121. Namely, the back surface field regions 172 may be formed by depositing an intrinsic polycrystalline silicon layer on the back surface of the metal oxide layer TMO and then injecting impurities of the second conductive type into the intrinsic polycrystalline silicon layer. Alternatively, the back surface field regions 172 may be formed by depositing an intrinsic amorphous silicon layer on the back surface of the metal oxide layer TMO, recrystallizing the intrinsic amorphous silicon layer into an intrinsic polycrystalline silicon layer through a thermal processing operation, and injecting impurities of the second conductive type into the recrystallized intrinsic polycrystalline silicon layer.

Thicknesses T121 and T172 of the emitter region 121 and the back surface field region 172 may be 100 nm to 300 nm. FIGS. 1 and 2 show that the thicknesses T121 and T172 of the emitter region 121 and the back surface field region 172 are equal to each other, as an example. However, the thicknesses T121 and T172 of the emitter region 121 and the back surface field region 172 may be different from each other.

The intrinsic semiconductor layer 150 may be formed in a space between the emitter region 121 and the back surface field region 172 in the back surface of the metal oxide layer TMO while directly contacting the back surface of the metal oxide layer TMO. The intrinsic semiconductor layer 150 may be formed of intrinsic polycrystalline silicon, which is not doped with impurities of the first conductive type and impurities of the second conductive type, unlike the emitter regions 121 and the back surface field regions 172.

Thus, the intrinsic semiconductor layer 150 may be formed using the same method as the emitter regions 121 and the back surface field regions 172, except that impurities of the first conductive type and impurities of the second conductive type are doped. The intrinsic semiconductor layer 150 may be formed at the same time as the emitter regions 121 and the back surface field regions 172.

As described above, the intrinsic semiconductor layer 150 may be formed in a space between the emitter region 121 and the back surface field region 172 in the back surface of the metal oxide layer TMO. In this instance, as shown in FIGS. 1 and 2, both sides of the intrinsic semiconductor layer 150 may directly contact the side of the emitter region 121 and the side of the back surface field region 172, respectively.

The passivation layer 190 removes a defect resulting from a dangling bond formed in a back surface of the intrinsic polycrystalline silicon layer formed at the back surface field region 172, the intrinsic semiconductor layer 150, and the emitter region 121, and thus can prevent or reduce carriers produced in the semiconductor substrate 110 from being recombined and disappeared or annihilated by the dangling bond.

For this, the passivation layer 190 may fully cover the back surface of the intrinsic semiconductor layer 150, cover a remaining portion excluding a portion connected to the first electrode 141 from a back surface of the emitter region 121, and cover a remaining portion excluding a portion connected to the second electrode 142 from a back surface of the back surface field region 172.

The passivation layer 190 may be formed of a dielectric layer. For example, the passivation layer 190 may include a single layer or a plurality of layers formed of at least one of hydrogenated silicon nitride (SiNx:H), hydrogenated silicon oxide (SiOx:H), hydrogenated silicon nitride oxide (SiNxOy:H), hydrogenated silicon oxynitride (SiOxNy:H), or hydrogenated amorphous silicon (a-Si:H).

The first electrode 141 may be in the plural. The plurality of first electrodes 141 may be respectively positioned on the plurality of emitter regions 121, may extend along the emitter regions 121 in the first direction x, and may be electrically and physically connected to the emitter regions 121. Thus, each first electrode 141 may collect carriers (for example, holes) moving to the corresponding emitter region 121.

The second electrode 142 may be in the plural. The plurality of second electrodes 142 may be respectively positioned on the plurality of back surface field regions 172, may extend along the back surface field regions 172 in the first direction x, and may be electrically and physically connected to the back surface field regions 172. Thus, each second electrode 142 may collect carriers (for example, electrons) moving to the corresponding back surface field regions172.

The plurality of first and second electrodes 141 and 142 may be formed of a conductive metal material. For example, the plurality of first and second electrodes 141 and 142 may be formed of at least one conductive material selected from the group consisting of nickel (Ni), copper (Cu), silver (Ag), aluminum (Al), tin (Sn), zinc (Zn), indium (In), titanium (Ti), gold (Au), and a combination thereof. Alternatively, the plurality of first and second electrodes 141 and 142 may be formed of a transparent conductive metal, for example, transparent conductive oxide (TCO).

As shown in FIGS. 1 and 2, the embodiment of the invention may form the metal oxide layer TMO on the back surface of the semiconductor substrate 110, so as to block the above-described leakage current in the intrinsic semiconductor layer 150.

The metal included in the metal oxide layer TMO may include at least one of a transition metal or a post-transition metal.

More specifically, the metal oxide layer TMO may be formed of transition metal oxide, for example, at least one of NiO, TiO₂, HfO₂, ZrO, WO, CuO, or Ta₂O₅. Alternatively, the metal oxide layer TMO may be formed of post-transition metal oxide, for example, Al₂O₃.

As shown in FIG. 2, the metal oxide layer TMO includes a first portion TMO1 between the semiconductor substrate 110 and the emitter region 121, a second portion TMO2 between the semiconductor substrate 110 and the back surface field region 172, and a third portion TMO3 between the semiconductor substrate 110 and the intrinsic semiconductor layer 150. Herein, when the solar cell is operating, the first portion and the second portion can be turned on and have a conductive state and the third portion can be turned off and has an insulated state. Hence, the metal oxide layer TMO can prevent the leakage current, which causes a portion of carriers produced in the semiconductor substrate 110 to be recombined and disappeared or annihilated in the intrinsic semiconductor layer 150.

A thickness T1 of the metal oxide layer TMO according to the embodiment of the invention may be greater than the thickness T180 of the tunnel layer 180 and may be less than the thickness T121 of the emitter region 121 or the thickness T172 of the back surface field region 172. More preferably, the thickness T1 of the metal oxide layer TMO may be 5 nm to 50 nm. More specifically, when a voltage is applied between the front surface and the back surface of the metal oxide layer TMO, a current may flow in the metal oxide layer TMO. In this instance, a critical voltage, which makes the current flow in the metal oxide layer TMO, may vary depending on the thickness T1 of the metal oxide layer TMO. As described above, when the thickness T1 of the metal oxide layer TMO is 5 nm to 50 nm, the critical voltage of the metal oxide layer TMO applicable to the solar cell according to the embodiment of the invention may be set as low as possible.

More specifically, when the thickness T1 of the metal oxide layer TMO is equal to or greater than 5 nm, the critical voltage of the metal oxide layer TMO may be prevented from being excessively reduced. Further, when the thickness T1 of the metal oxide layer TMO is equal to or less than 50 nm, the critical voltage of the metal oxide layer TMO may be prevented from excessively increasing.

As described above, when the thickness T1 of the metal oxide layer TMO is 5 nm to 50 nm, the critical voltage may be 0.7V to 1V. Preferably, the critical voltage may be about 0.7V.

When there is no voltage difference between the front surface and the back surface of the metal oxide layer TMO or the voltage difference is less than the critical voltage, the metal oxide layer TMO may have a resistance of 10 MΩ to 100 MΩ, for example. When the voltage difference between the front surface and the back surface of the metal oxide layer TMO is equal to or greater than the critical voltage, the metal oxide layer TMO may have a resistance equal to or less than 10 Ω and greater than 0 Ω.

When the metal oxide layer TMO is formed as in the embodiment of the invention, a band off voltage resulting from a p-n junction or a voltage difference resulting from an impurity doping concentration may be generated between front and back surfaces of the first portion TMO1 and between front and back surfaces of the second portion TMO2 in the metal oxide layer TMO and may be equal to or greater than the critical voltage. There is no voltage difference between front and back surfaces of the third portion TMO3, or the voltage difference may be less than the critical voltage.

Accordingly, the current may flow through the first portion TMO1 and the second portion TMO2 of the metal oxide layer TMO, and at the same time, the current may not flow through the third portion TMO3 and may be blocked.

A soft break down process, for applying a voltage equal to or greater than the critical voltage between the first and second electrodes 141 and 142 in an initial operation of the solar cell to turn on the first portion TMO1 and the second portion TMO2 of the metal oxide layer TMO, may be necessary to operate the solar cell having the above-described configuration.

A drive of the solar cell including the metal oxide layer TMO is described in detail below.

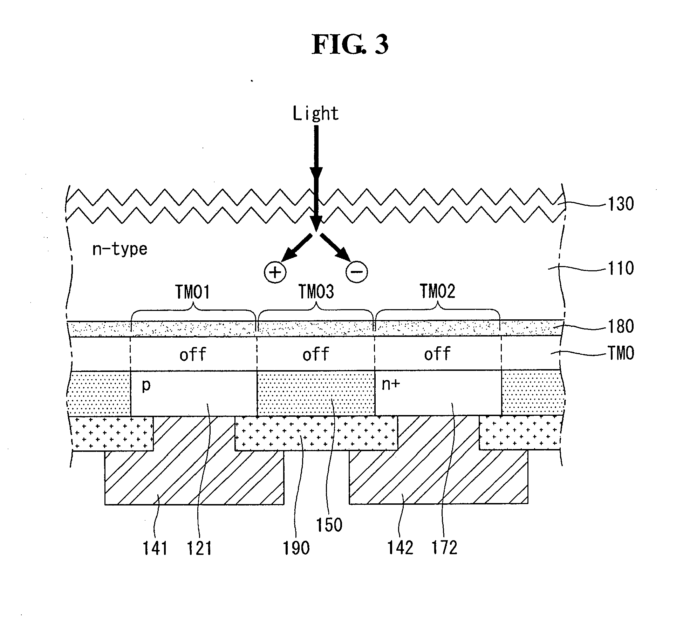

FIGS. 3 to 5 illustrate a method for driving the solar cell including the metal oxide layer TMO according to the embodiment of the invention.

FIGS. 3 to 5 show that the first conductive type is the n-type and the second conductive type is the p-type, as an example. In another embodiment, even when the first conductive type is the p-type and the second conductive type is the n-type unlike FIGS. 3 to 5, the metal oxide layer TMO according to the embodiment of the invention may be equally or similarly applied.

As described above, the soft break down process may be necessary to drive the solar cell including the metal oxide layer TMO according to the embodiment of the invention.

More specifically, as shown in FIG. 3, the plurality of solar cells may be connected in series to form a solar cell module, and light may be incident on the inside of the solar cell module. In this instance, even if carriers such as electrons (-) and holes (+) are generated in the semiconductor substrate 110 by light incident on the solar cell including the metal oxide layer TMO, there is no carrier collected in the emitter region 121 connected to the first electrode 141 and the back surface field region 172 connected to the second electrode 142. Hence, all of the first portion TMO1, the second portion TMO2, and the third portion TMO3 of the metal oxide layer TMO may be in an off-state having a resistance of 10 MΩ to 100 MΩ.

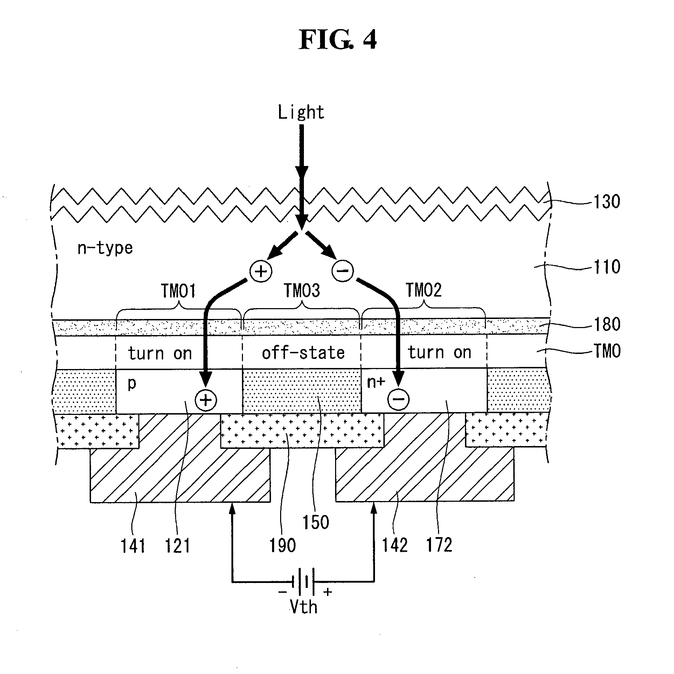

However, as shown in FIG. 4, when a voltage equal to or greater than a critical voltage Vth is applied so that a negative (-) polarity is connected to the first electrode 141 and a positive (+) polarity is connected to the second electrode 142, the voltage equal to or greater than the critical voltage Vth may be formed at the front and back surfaces of the first portion TMO1 and the front and back surfaces of the second portion TMO2 of the metal oxide layer TMO. Hence, the soft break down may be generated in the first portion TMO1 and the second portion TMO2 of the metal oxide layer TMO, and the first portion TMO1 and the second portion TMO2 may be turned on and may have a resistance equal to or less than 10 Ω and greater than 0 Ω. Because the voltage is not applied to the third portion TMO3 of the metal oxide layer TMO, the third portion TMO3 may be maintained in the off-state.

Accordingly, holes (+) produced in the semiconductor substrate 110 move to the emitter region 121 through the first portion TMO1 of the metal oxide layer TMO and are combined with electrons (-) of the first electrode 141, and electrons (-) produced in the semiconductor substrate 110 move to the back surface field region 172 through the second portion TMO2 of the metal oxide layer TMO and are combined with holes (+) of the second electrode 142. Hence, a current path may be formed.

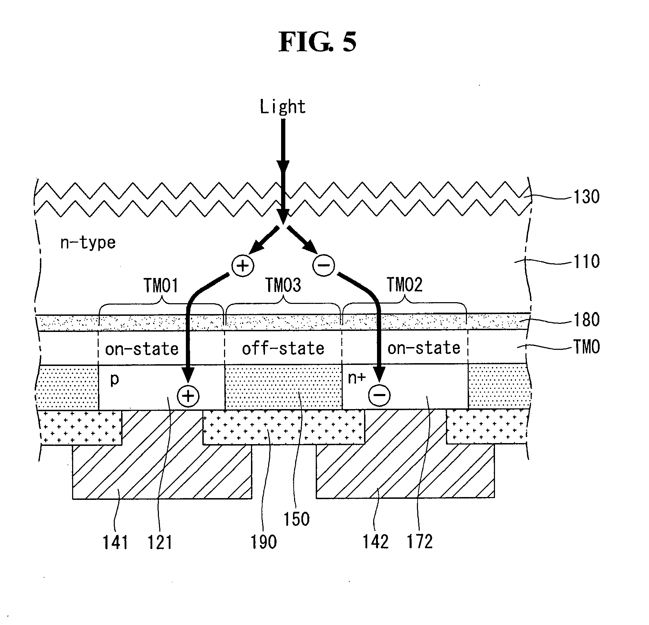

As described above, after the soft break down is generated in the metal oxide layer TMO by applying the voltage equal to or greater than the critical voltage Vth to the solar cell, the voltage applied to the solar cell is removed. However, in this instance, as shown in FIG. 5, carriers produced in the semiconductor substrate 110 may continuously move to the emitter region 121 and the back surface field region 172 through the first portion TMO1 and the second portion TMO2 of the metal oxide layer TMO. In such a state, the first portion TMO1 and the second portion TMO2 of the metal oxide layer TMO may be maintained in the on-state, and the third portion TMO3 may be maintained in the off-state.

Accordingly, as shown in FIG. 5, when the solar cell operates, carriers may move through the first portion TMO1 and the second portion TMO2 of the metal oxide layer TMO and may not move through the third portion TMO3 between the semiconductor substrate 110 and the intrinsic semiconductor layer 150.

As a result, the solar cell according to the embodiment of the invention previously blocks carriers from moving to the intrinsic semiconductor layer 150 by the metal oxide layer TMO and can prevent the leakage current, which causes carriers to be recombined and disappeared or annihilated in the intrinsic semiconductor layer 150.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell comprising:
a semiconductor substrate containing impurities of a first conductive type;
a metal oxide layer positioned on the semiconductor substrate;
an emitter region positioned on the metal oxide layer and having a second conductive type opposite the first conductive type;
a first electrode connected to the emitter region; and
a second electrode connected to the semiconductor substrate.

2. The solar cell of claim 1, wherein a metal included in the metal oxide layer includes at least one of a transition metal or a post-transition metal.

3. The solar cell of claim 1 or 2, wherein the metal oxide layer is formed of one of NiO, TiO₂, HfO₂, ZrO, WO, CuO, Ta₂O₅, and Al₂O₃.

4. The solar cell of any one preceding claim, wherein the metal oxide layer and the emitter region are positioned on a back surface of the semiconductor substrate.

5. The solar cell of claim 4, further comprising a back surface field region positioned on the metal oxide layer and containing impurities of the first conductive type at a higher concentration than the impurities of the semiconductor substrate.

6. The solar cell of claim 5, wherein the emitter region and the back surface field region are formed of a polycrystalline silicon material.

7. The solar cell of claim 5 or 6, further comprising an intrinsic semiconductor layer positioned on a back surface of the metal oxide layer,
wherein the emitter region and the back surface field region are positioned to be separated from each other with the intrinsic semiconductor layer interposed therebetween.

8. The solar cell of any one of claims 5 to 7, further comprising a tunnel layer positioned between the semiconductor substrate and the metal oxide layer and configured to pass through carriers produced in the semiconductor substrate, the tunnel layer being formed of a dielectric material.

9. The solar cell of claim 8, wherein a thickness of the metal oxide layer is greater than a thickness of the tunnel layer and is less than a thickness of the emitter region or a thickness of the back surface field region.

10. The solar cell of claim 9, wherein the thickness of the metal oxide layer is 5 nm to 50 nm.

11. The solar cell of any one preceding claim, wherein when a voltage equal to or greater than a critical voltage is applied to front and back surfaces of the metal oxide layer, the metal oxide layer has a resistance equal to or less than 10 Ω and greater than 0 Ω,
wherein when a voltage less than the critical voltage is applied to the front and back surfaces of the metal oxide layer or a voltage is not applied to the front and back surfaces of the metal oxide layer, the metal oxide layer has a resistance of 10 MΩ to 100 MΩ, and
wherein the critical voltage is 0.7V to 1V.

12. The solar cell of any one of claims 5 to 11, wherein when the solar cell operates, carriers produced in the semiconductor substrate move through a first portion in the metal oxide layer between the semiconductor substrate and the emitter region and a second portion in the metal oxide layer between the semiconductor substrate and the back surface field region and does not move through a third portion in the metal oxide layer between the semiconductor substrate and the intrinsic semiconductor layer.

13. The solar cell of any one of claims 8 to 12, wherein the dielectric material of the tunnel layer includes silicon carbide (SiCx) or silicon oxide (SiOx).

14. The solar cell of any one of claims 8 to 13, wherein the tunnel layer has a thickness of 0.5 nm to 2.5 nm.

15. The solar cell of any one of claims 5 to 14, further comprising a passivation layer positioned on back surfaces of the emitter region, the back surface field region, and the intrinsic semiconductor layer, and
wherein the passivation layer includes at least one of hydrogenated silicon nitride (SiNx:H), hydrogenated silicon oxide (SiOx:H), hydrogenated silicon nitride oxide (SiNxOy:H), hydrogenated silicon oxynitride (SiOxNy:H), or hydrogenated amorphous silicon (a-Si:H).
